# EUROPEAN PATENT SPECIFICATION

(11) **EP 4 022 695 B1**
(45) Date of publication and mention of the grant of the patent: **25.12.2024**
(21) Application number: 20750242.8
(22) Date of filing: 30.07.2020
(51) Int. Cl.: H02N 2/18, H10N 30/30, H10N 30/857

(54) **CANTILEVER FOR A PIEZOELECTRIC ENERGY HARVESTING SYSTEM**
AUSLEGER FÜR EIN PIEZOELEKTRISCHES ENERGIE-ERNTE-SYSTEM
CANTILEVER POUR UN SYSTÈME DE RÉCOLTE D'ÉNERGIE PIÉZOÉLECTRIQUE

(43) Date of publication of application: 06.07.2022
(73) Proprietor: UAB Nanoenergija, 65192 Varena (LT)
(72) Inventor: MARKEVICIUS, Vytautas, Kaunas (LT); PONAMARIOV, Donat, Vilnius (LT)
(74) Representative: Leffers, Thomas
(86) International application number: PCT/EP2020/071552
(87) International publication number: WO 2022/022831

(56) References cited:
- WO-A1-2015/077200
- JP-A- 2019 172 787
- US-A1- 2013 154 439
- US-A1- 2016 254 437

## Description

The present application relates to a cantilever for an energy harvesting system and, in particular, to an improved cantilever for a piezoelectric energy harvesting system.

There are many unutilized energy sources in the environment, for example, thermal energy, electromagnetic waves, and mechanical vibrations. To convert these ambient energies into electric energy, energy harvesting technologies have been developed. Energy harvesting technologies can, for example, be used as an energy source for a battery of a wireless sensor. There are further various energy sources for energy harvesting such as solar power, thermal energy, wind power, and vibration. Further, there are three main types of vibration energy harvesters generation methods: electromagnetic, electrostatic, and piezoelectric.

Therein, energy harvesting technology using piezoelectric materials is one such method that utilizes mechanical energy from various sources such as human motion, acoustic noise, or wind to convert energy into an electric current. When mechanical energy such as an acoustic wave is applied to a piezoelectric polymer film, electrical charges are induced between the two surfaces. Using this property, a piezoelectric material can be applied as an electromechanical energy converter.

The document US 7,649,305 B2 discloses a mechanism for capturing mechanical energy and converting it to electrical energy for use in continually charging or providing emergency power to mobile, battery-powered devices, which comprises a plurality of elongated piezoelectric elements mounted at one or more support points to one or more support structures. The plurality of piezoelectric elements are preferably structured and arranged so that at least each three-dimensional coordinate axis has at least one element with a dominant mode of deflection in a plane normal to the axis, to permit harvesting energy from forces applied in any direction without regard to the orientation of the energy harvesting mechanism to the source of forces.

Among piezoelectric materials, respectively polymers which have strong piezoelectric effects when subjected to mechanical stretching or external excitation, polyvinylidene fluoride (PVDF) films have a comparatively high piezoelectric effect and are, at the same time, cheap and easy to manufacture, chemically inert, lightweight and safe to us. However, as these films are usually very thin, polyvinylidene fluoride films are usually not used as a basis for piezoelectric energy harvesting systems due to their fragility and the very short response times.

The document US 2016/254437 A1 discloses a cantilever for a piezoelectric energy harvesting system which comprises layers formed of polyvinylidene fluoride.

The document WO 2015/077200 A1 discloses a touch panel which comprises a piezoelectric layer formed of polyvinylidene fluoride.

The document US 2013/154439 A1 discloses an energy harvesting device which comprises a piezoelectric layer formed of polyvinylidene fluoride.

The document JP 2019 172787 A discloses a stretched film containing polyvinylidene fluoride and poly(meth)acrylic acid ester, wherein the polyvinylidene fluoride component has a β crystal fraction of 85% or more and 100% or less.

It is an object of the present invention to provide an improved cantilever for a piezoelectric energy harvesting system.

This object is solved by the cantilever according to claim 1.

According to the independent device claim 1, the present invention is directed to a a cantilever for a piezoelectric energy harvesting system.

Therefore, a cantilever for a piezoelectric energy harvesting system is provided, which is based on polyvinylidene fluoride films. Thus, it can be taken full advantage of the use of polyvinylidene fluoride as a piezoelectric material, and, in particular, that polyvinylidene fluoride films have a comparatively high piezoelectric effect and are, at the same time, cheap and easy to manufacture, chemically inert, lightweight and safe to us. On the other hand, however, the problems that usually arise when a cantilever for a piezoelectric energy harvesting system should be based on polyvinylidene fluoride films can be neglected, due to the configuration of the cantilever. For example, the fragility of the cantilever based on polyvinylidene fluoride can be reduced by placing a core layer formed of a shim material between the two layers formed of polyvinylidene fluoride. Therefore, an improved cantilever for a piezoelectric energy harvesting system is provided.

Therein, the two layers formed of polyvinylidene fluoride have a predominantly β-type crystal structure. Polyvinylidene fluoride has four crystalline phases α, β, γ, and δ depending on the chain conformation. Among them, α is thermodynamically the most stable and nonpolar in-nature. β and γ are polar phases, wherein crystalline phase β is of great importance due to its spontaneous polarization and piezoelectric sensitivity. Thus, the cantilever can be further improved when the two layers formed of polyvinylidene fluoride have a predominantly β-type crystal structure.

Further, the cantilever can have the form of a rectangular plate, wherein the longitudinal sides of the rectangular plate are longer than the broadsides of the rectangular plate, and wherein the cantilever (is configured in such a way, that the cantilever can be connected to a device which stores or uses energy via one of the longitudinal sides. By configuring the cantilever in such a way, that a longer side of the cantilever can be electrically or electrically and mechanically connected to a device which stores or uses energy, the robustness can be further improved, and therefore, the fragility of the cantilever based on polyvinylidene fluoride be further reduced.

As shim materials, aluminum, steel, brass, and laminated plastic, respectively polyethylene terephthalate (PET) are commonly used.

Therein, according to one embodiment, the core layer can be formed of steel. The use of steel as material for the core layer has the advantage that the cantilever can vibrate in the greatest possible resonance frequency, wherein, at the same time, the vibration wave can be as long as possible.

Further, a core layer formed of steel preferably has a thickness between 50µm and 150µm, to achieve the greatest power output.

According to another embodiment, the core layer is formed of polyethylene terephthalate (PET). The use of polyethylene terephthalate as material for the core layer has the advantage that comparatively great power output can be achieved.

Further, a core layer formed of polyethylene terephthalate preferably has a thickness between 400µm and 560µm, to achieve the greatest power output.

Further, each of the two layers formed of polyvinylidene fluoride can have a thickness between 20µm and 50µm. That the polyvinylidene fluoride layers respectively have a thickness between 20µm and 50µm has the advantage, that applied kinetic stress can be converted in a very efficient way. Further, if the layers are too thin there is a potential for migration of extractants through the layers and potential attack from the contents to permeate through the PVDF layers and attack other materials in the construction. Thicker layers would additionally add unnecessary costs.

The two layers formed of polyvinylidene fluoride can respectively be bonded to the core layer by an epoxy resin. By using epoxy resin to secure the polyvinylidene fluoride layers to the core layer, the flexibility of the composition can be enhanced, wherein, at the same time, the risk of breakage of the composition can be further reduced. Furthermore, the use of epoxy resin results in excellent mechanical properties, as well as aging resistance, heat resistance, and corrosion resistance of the composition.

Further, electrodes can be formed on and under each of the two layers formed of polyvinylidene fluoride. By sandwiching the polyvinylidene fluoride layer between two electrodes, a simple, flexible, and compact design is provided capable of producing high volume power densities.

Therein, the electrodes can be formed of aluminum, nickel, or copper. Thus, the electrodes can simply be formed by sputtering metal on the polyvinylidene fluoride film, wherein the metallization of the PDVF film can include aluminum, nickel, or copper, and wherein an electrode can be provided that is more compliant and less susceptible. However, that the electrodes are formed of aluminum, nickel or cooper should merely be understood as an example and other materials can be used for forming the electrodes respectively a metallization on the polyvinylidene fluoride layer, too, for example, chromium, gold, silver, platinum, rhodium, alloys of any of the foregoing, and the like.

According to a further embodiment of the invention, a piezoelectric energy harvesting system is provided, which comprises a cantilever as described above and a device that stores or uses energy, wherein a first end of the cantilever is electrically connected to the device which stores or uses energy.

Therefore, a piezoelectric energy harvesting system is provided, which comprises a cantilever that is based on polyvinylidene fluoride films. Thus, it can be taken full advantage of the use of polyvinylidene fluoride as a piezoelectric material, and, in particular, that polyvinylidene fluoride films have a comparatively high piezoelectric effect and are, at the same time, cheap and easy to manufacture, chemically inert, lightweight and safe to us. On the other hand, however, the problems that usually arise when a cantilever for a piezoelectric energy harvesting system should be based on polyvinylidene fluoride films can be neglected, due to the configuration of the cantilever. For example, the fragility of the cantilever based on polyvinylidene fluoride films can be reduced by placing a core layer formed of a shim material between the two layers formed of polyvinylidene fluoride.

Further, at least one tip mass can be attached to a second end of the cantilever, wherein the second end of the cantilever is opposite the first end. By adding at least one tip weight to a second, free end of the cantilever, the level of vibrations can be increased and the resonance levels controlled.

Therein, a weight of the at least on tip mass can be customized, whereby the resonance frequency of the piezoelectric energy harvesting system can be customized to the real need of the application where it should work.

Furthermore, according to one embodiment, a first tip mass is attached to a top surface of the second end of the cantilever band a second tip mass is attached to a bottom surface of the second end of the cantilever. By placing such an additional mass on a surface of the cantilever opposite to a surface of the cantilever where the first tip mass is placed, a vibration time of the cantilever can be increased. Further, based on the ratio of the weight of the first tip mass to the weight of the second tip mass, the output voltage can be increased.

Embodiments of the invention will now be described with reference to the drawings.
- Figure 1: illustrates a piezoelectric energy harvesting system according to embodiments of the invention;
- Figure 2: illustrates a cantilever for a piezoelectric energy harvesting system according to a first embodiment of the invention;
- Figure 3: illustrates a cantilever for a piezoelectric energy harvesting system according to a second embodiment of the invention.

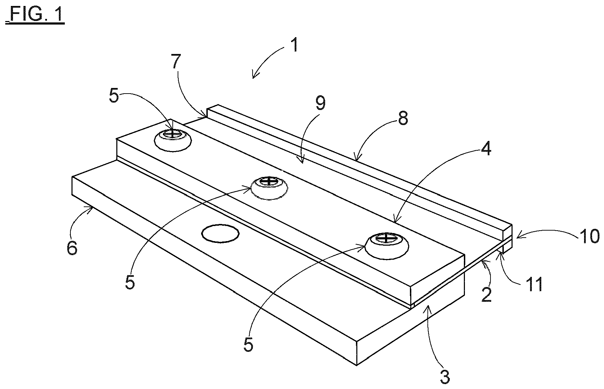

Figure 1 illustrates a piezoelectric energy harvesting system 1 according to embodiments of the invention.

As shown in figure 1, the piezoelectric energy harvesting system 1 comprises a cantilever 2 and a device 3 which stores or uses energy, wherein the device 3 includes a printed circuit board and electronic components, for example, a rectifier unit, a control unit and a storage device, such as a battery and capacitor. Further, a proximal or first end 4 of the cantilever 2 is mechanically and electrically connected to the device 3 which stores or uses energy. According to the embodiments of figure 1, the cantilever 2 is anchored into the device 3 and mechanically connected to the device 3 by screws 5. However, the cantilever is mechanically connected to the device by screws should merely be understood as an example and the cantilever can be mechanically connected to the device by other suitable fasteners, too. Figure 1 further shows a mounting part 6 via which the piezoelectric energy harvesting system can be attached to a device or holding structure.

Piezoelectric energy harvesting systems 1 comprise elements that cause bending, contraction, extraction, etc. in a piezoelectric layer using vibration or pressure and thus generate an alternating current voltage by a piezoelectric effect. Thus, kinetic energy is converted into electrical energy.

These piezoelectric energy harvesting systems 1 are variously applied in that they can use pressure or vibration caused by the exercise of a person, pressure or vibration caused by a vehicle such as a car, and pressure or vibration caused by a natural environment, etc.

Among possible piezoelectric materials, polyvinylidene fluoride (PVDF) films have a comparatively high piezoelectric effect and are, at the same time, cheap and easy to manufacture, chemically inert, lightweight and safe to us. However, as polyvinylidene fluoride films are usually very thin, polyvinylidene fluoride films are usually not used as a basis for piezoelectric energy harvesting systems due to their fragility and the very short response times.

According to the embodiments of figure 1, the cantilever 2 comprises two layers formed of polyvinylidene fluoride, wherein a core layer formed of a shim material is sandwiched between the two layers formed of polyvinylidene fluoride.

Therefore, a cantilever 2 for a piezoelectric energy harvesting system 1 is provided, which is based on polyvinylidene fluoride films. Thus, it can be taken full advantage of the use of polyvinylidene fluoride as a piezoelectric material, and, in particular, that polyvinylidene fluoride films have a comparatively high piezoelectric effect and are, at the same time, cheap and easy to manufacture, chemically inert, lightweight and safe to us. On the other hand, however, the problems that usually arise when a cantilever for a piezoelectric energy harvesting system should be based on polyvinylidene fluoride films can be neglected, due to the configuration of the cantilever. For example, the fragility of the cantilever based on polyvinylidene fluoride can be reduced by placing a core layer formed of a shim material between the two layers formed of polyvinylidene fluoride. Therefore, an improved cantilever for a piezoelectric energy harvesting system is provided.

According to the embodiments of figure 1, the layers formed of polyvinylidene fluoride are arranged in such a way, that during bending one of the layers (e.g. top layer) is generating the positive charge, whereas the other layer, placed on the opposite side of the core (e.g. bottom layer) also is generating the positive charge, and wherein the two layers are connected in parallel.

In the shown piezoelectric energy harvesting system 1, the level of vibrations amplitude can be increased and the resonance levels controlled by attaching at least one tip mass to a distal or second, free end 7 of the cantilever 2.

Therein, according to the embodiments of figure 1, a first tip mass 8 is attached to a top surface 9 of the second end 8 of the cantilever 2, and a second tip mass 10 is attached to a bottom surface 11 of the second end 8 of the cantilever 2. The tip mass 8,10 can, for example, be formed by using a high-density metal such as tungsten, iron, etc.

Further, the first 8 and the second tip mass 10 are configured to be customized to the real need of the application where it should work. For example, in a known application, the first tip mass is chosen to have a weight of 12g, and the second tip mass is chosen to have a weight of 7g.

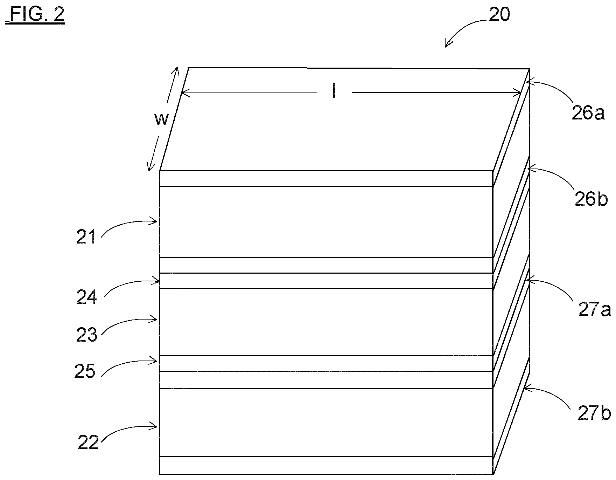

Figure 2 illustrates a cantilever 20 for a piezoelectric energy harvesting system according to a first embodiment of the invention.

The shown cantilever 20 comprises two layers 21,22 formed of polyvinylidene fluoride, wherein a core layer 23 formed of a shim material is sandwiched between the two layers 21,22 formed of polyvinylidene fluoride.

Therein, the two layers 21,22 formed of polyvinylidene fluoride respectively have a predominantly β-type crystal structure. Each of the two layers 21,22 formed of polyvinylidene fluoride can, for example, be poled to change its phase from α to β by placing the layer under a high electrical field and heating it to a certain temperature, wherein the layer is kept or maintained under the high electrical field for a required amount of time.

Further, the shown cantilever 20 has the form of a rectangular plate, wherein the longitudinal sides of the rectangular plate are longer than the broadsides of the rectangular plate, and wherein the cantilever 20 is configured in such a way, that the cantilever 20 can be connected to a device which stores or uses energy via one of the longitudinal sides.

According to the invention, each of the layers formed of polyvinylidene fluoride is be prepared in such a way, that it has a length between 60mm and 80mm and a width between 10mm and 20mm. In particular, according to the embodiments of figure 2, each of the polyvinylidene fluoride layers has a length I of 74 mm and a width w of 13 mm. However, that each of the polyvinylidene fluoride layers has a length of 74 mm, and a width of 13 mm should merely be understood as an example, and each of the polyvinylidene fluoride layers can for example also have a length of 64mm and a width of 12 mm. Further, the stated dimensions are merely examples and the cantilever can have different lengths and widths, too, for example lenghts from 10 mm to 150 mm or even more.

According to the first embodiment, the core layer 23 is formed of steel. The use of steel as the material for the core layer has the advantage that the cantilever can vibrate in the greatest possible resonance frequency, wherein, at the same time, the vibration wave can be as long as possible.

Therein, the core layer 23 formed of steel has a thickness between 50µm and 150µm, to achieve the greatest power output.

Further, each of the two layers formed of polyvinylidene fluoride has a thickness between 20µm and 50µm, to convert the applied kinetic stress in a very efficient way.

As shown in figure 2, adhesive layers 24,25 are further formed to respectively secure the layers formed of polyvinylidene fluoride 21,22 to the core layer 23. Therein, an epoxy resin is used to respectively bond the layers 21,22 formed of polyvinylidene fluoride to the core layer 23.

There are further shown layer electrodes 26a,26b,27a,27b which are formed on and under each of the two layers 21,22 formed of polyvinylidene fluoride. These electrodes 26a,26b,27a,27b can be formed to a thickness of several tens to hundreds of nanometers, and can, for example, be formed through a sputtering deposition method.

Further, the electrodes 26a,26b,27a,27b are formed of one of aluminum, nickel, or copper. However, that the electrodes are formed of aluminum, nickel or cooper should merely be understood as an example and other materials can be used for forming the electrodes respectively a metallization on the polyvinylidene fluoride layer, too, wherein the materials for metallization can include chromium, gold, silver, platinum, rhodium, alloys of any of the foregoing, and the like.

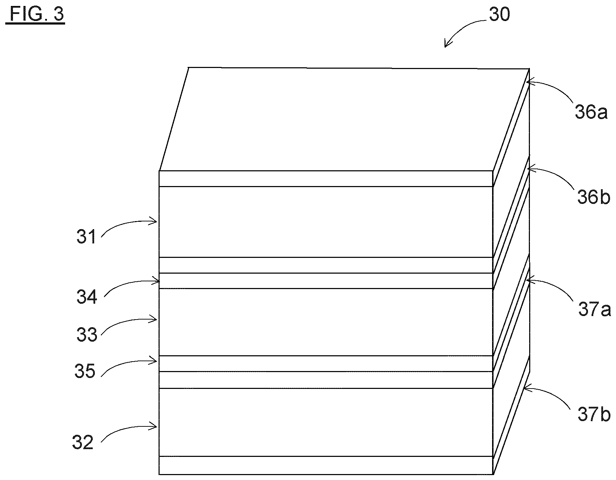

Figure 3 illustrates a cantilever 30 for a piezoelectric energy harvesting system according to a first embodiment of the invention.

As shown in figure 3, similar to the cantilever 20 according to the first embodiment, the cantilever 30 according to the second embodiment comprises two layers 31,32 formed of polyvinylidene fluoride, wherein a core layer 33 formed of a shim material is sandwiched between the two layers 31,32 formed of polyvinylidene fluoride, wherein the two layers 31,32 are respectively bonded to the core layer 33 by an adhesive layer 34,35 of epoxy resin, and wherein layer electrodes 36a,36b,37a,37b are formed on and under each of the two layers 31,32 formed of polyvinylidene fluoride.

The difference between the cantilever 30 according to the second embodiment shown in figure 3 and the cantilever 20 according to the first embodiment shown in figure 2 is that the core layer 33 of the cantilever 30 according to the second embodiment is formed of polyethylene terephthalate (PET), whereby a comparatively great power output can be achieved.

Therein, the core layer 33 formed of polyethylene terephthalate has a thickness between 400µm and 560µm, to achieve the greatest power output.

### Reference signs

1 piezoelectric energy harvesting system
2 cantilever
3 device
4 first end
5 screw
6 mounting part
7 second end
8 first tip mass
9 top side
10 second tip mass
11 bottom side
20 cantilever
21 Layer
22 Layer
23 Core layer
24 Adhesive layer
25 Adhesive layer
26a electrode
26b electrode
27a electrode
27b electrode
30 cantilever
31 layer
32 layer
33 core layer
34 adhesive layer
35 adhesive layer
36a electrode
36b electrode
37a electrode
37b electrode
I length
w width

## Claims

1. Cantilever for a piezoelectric energy harvesting system, wherein the cantilever (2,20,30) comprises two layers (21,22,31,32) formed of polyvinylidene fluoride, and wherein a core layer (23,33) formed of a shim material is sandwiched between the two layers (21,22,31,32) formed of polyvinylidene fluoride, **characterized in that** the two layers (21,22,31,32) formed of polyvinylidene fluoride respectively have a predominantly β-type crystal structure, wherein the two layers formed of polyvinylidene fluoride (21,22,31,32) respectively have a length between 60mm and 80mm and a width between 10mm and 20mm.

2. Cantilever according to claim 1, wherein the cantilever (20,30) has the form of a rectangular plate, wherein the longitudinal sides of the rectangular plate are longer than the broadsides of the rectangular plate, and wherein the cantilever (20,30) is configured to be connected to a device which stores or uses energy via one of the longitudinal sides.

3. Cantilever according to claim 1 or 2, wherein the core layer (23) is formed of steel.

4. Cantilever according to claim 3, wherein the core layer (23) has a thickness between 50µm and 150µm.

5. Cantilever according to claim 1 or 2, wherein the core layer (33) is formed of polyethylene terephthalate.

6. Cantilever according to claim 5, wherein the core layer (33) has a thickness between 400µm and 560µm.

7. Cantilever according to one of claims 1 to 6, wherein each of the two layers (21,22,31,32) formed of polyvinylidene fluoride has a thickness between 20µm and 50µm.

8. Cantilever according to one of claims 1 to 7, wherein the two layers (21,22,31,32) formed of polyvinylidene fluoride are respectively bonded to the core layer (23,33) by an epoxy resin.

9. Cantilever according to one of claims 1 to 8, wherein electrodes (26a,26b,27a,27b,36a,36b,37a,37b) are formed on and under each of the two layers (21,22,31,32) formed of polyvinylidene fluoride.

10. Cantilever according to claim 9, wherein the electrodes (26a,26b,27a,27b,36a,36b,37a,37b) are formed of aluminum, nickel or cooper.

11. Piezoelectric energy harvesting system, wherein the system (1) comprises a cantilever (2) according to one of claims 1 to 10 and a device (3) which stores or uses energy, and wherein a first end (4) of the cantilever (2) is electrically connected to the device (3) which stores or uses energy.

12. Piezoelectric energy harvesting system according to claim 11, wherein at least one tip mass (8,10) is attached to a second end (7) of the cantilever (2), wherein the second end (7) of the cantilever (2) is opposite the first end (4).

13. Piezoelectric energy harvesting system according to claim 12, wherein a weight of the at least on tip mass (8,10) is configured to be customized by the resonance frequency of the piezoelectric energy harvesting system.

14. Piezoelectric energy harvesting system according to claim 12 or 13, wherein a first tip mass (8) is attached to a top side (9) of the second end (7) of the cantilever (2), and wherein a second tip mass (10) is attached to a bottom side (11) of the second end (7) of the cantilever (2).

## Patentansprüche

1. Ausleger für ein piezoelektrisches Energiegewinnungssystem, wobei der Ausleger (2, 20, 30) zwei aus Polyvinylidenfluorid gebildete Schichten (21, 22, 31, 32) aufweist, und wobei eine Kernschicht (23, 33), die aus einem Zwischen-Material gebildet ist, zwischen den beiden aus Polyvinylidenfluorid gebildeten Schichten (21, 22, 31, 32) angeordnet ist, **dadurch gekennzeichnet, dass** die beiden aus Polyvinylidenfluorid gebildeten Schichten (21, 22, 31, 32) jeweils überwiegend eine β-Typ-Kristallstruktur aufweisen, wobei die beiden aus Polyvinylidenfluorid gebildeten Schichten (21, 22, 31, 32) jeweils eine Länge zwischen 60 mm und 80 mm und eine Breite zwischen 10 mm und 20 mm aufweisen.

2. Ausleger nach Anspruch 1, wobei der Ausleger (20, 30) die Form einer rechteckigen Platte aufweist, wobei die Längsseiten der rechteckigen Platte länger sind als die Breitseiten der rechteckigen Platte, und wobei der Ausleger (20, 30) so konfiguriert ist, dass er über eine der Längsseiten mit einer Vorrichtung verbunden ist, die Energie speichert oder nutzt.

3. Ausleger nach Anspruch 1 oder 2, wobei die Zwischenschicht (23) aus Stahl gebildet ist.

4. Ausleger nach Anspruch 3, wobei die Zwischenschicht (23) eine Dicke zwischen 50µm und 150µm aufweist.

5. Ausleger nach Anspruch 1 oder 2, wobei die Zwischenschicht (33) aus Polyethylenterephthalat gebildet ist.

6. Ausleger nach Anspruch 3, wobei die Zwischenschicht (33) eine Dicke zwischen 400µm und 560µm aufweist.

7. Ausleger nach einem der Ansprüche 1 bis 6, wobei jede der beiden aus Polyvinylidenfluorid gebildeten Schichten (21, 22, 31, 32) eine Dicke zwischen 20 µm und 50 µm aufweist.

8. Ausleger nach einem der Ansprüche 1 bis 7, wobei die zwei aus Polyvinylidenfluorid gebildeten Schichten (21, 22, 31, 32) jeweils durch ein Epoxidharz an die Kernschicht (23, 33) gebondet sind.

9. Ausleger nach einem der Ansprüche 1 bis 8, wobei Elektroden (26a, 26b, 27a, 27b, 36a, 36b, 37a, 37b) auf und unter jeder der zwei aus Polyvinylidenfluorid gebildeten Schichten (21, 22, 31, 32) ausgebildet sind.

10. Ausleger nach Anspruch 9, wobei die Elektroden (26a, 26b, 27a, 27b, 36a, 36b, 37a, 37b) aus Aluminium, Nickel oder Kupfer gebildet sind.

11. Piezoelektrisches Energiegewinnungssystem, wobei das System (1) einen Ausleger (2) nach einem der Ansprüche 1 bis 10 und eine Vorrichtung (3), die Energie speichert oder nutzt, aufweist, und wobei ein erstes Ende (4) des Auslegers (2) elektrisch mit der Vorrichtung (3), die Energie speichert oder nutzt, verbunden ist.

12. Piezoelektrisches Energiegewinnungssystem nach Anspruch 11, wobei mindestens eine Spitzenmasse (8, 10) an einem zweiten Ende (7) des Auslegers (2) angebracht ist, wobei das zweite Ende (7) des Auslegers (2) dem ersten Ende (4) gegenüberliegt.

13. Piezoelektrisches Energiegewinnungssystem nach Anspruch 12, wobei ein Gewicht der Spitzenmasse (8, 10) konfiguriert ist, basierend auf der Resonanzfrequenz des piezoelektrischen Energiegewinnungssystems angepasst zu werden.

14. Piezoelektrisches Energiegewinnungssystem nach Anspruch 12 oder 13, wobei eine erste Spitzenmasse (8) an einer Oberseite (9) des zweiten Endes (7) des Auslegers (2) angebracht ist und wobei eine zweite Spitzenmasse (10) an einer Unterseite (11) des zweiten Endes (7) des Auslegers (2) angebracht ist.

## Revendications

1. Cantilever pour un système de collecte d'énergie piézoélectrique, dans lequel le cantilever (2,20,30) comprend deux couches (21,22,31,32) formées de fluorure de polyvinylidène, et dans lequel une couche centrale (23,33) formée d'un matériau de calage est prise en sandwich entre les deux couches (21,22,31,32) formées de fluorure de polyvinylidène, **caractérisé en ce que** les deux couches (21,22,31,32) formées de fluorure de polyvinylidène ont respectivement une structure cristalline de type β prédominante, dans laquelle les deux couches formées de fluorure de polyvinylidène (21,22,31,32) ont respectivement une longueur comprise entre 60 mm et 80 mm et une largeur comprise entre 10 mm et 20 mm.

2. Cantilever selon la revendication 1, dans lequel le cantilever (20,30) a la forme d'une plaque rectangulaire, dans lequel les côtés longitudinaux de la plaque rectangulaire sont plus longs que les côtés larges de la plaque rectangulaire, et dans lequel le cantilever (20,30) est configuré pour être connecté à un dispositif qui stocke ou utilise de l'énergie par l'intermédiaire de l'un des côtés longitudinaux.

3. Cantilever selon la revendication 1 ou 2, dans lequel la couche centrale (23) est formée d'acier.

4. Cantilever selon la revendication 3, dans lequel la couche centrale (23) a une épaisseur comprise entre 50µm et 150µm.

5. Cantilever selon la revendication 1 ou 2, dans lequel la couche centrale (33) est formée de polyéthylène téréphtalate.

6. Cantilever selon la revendication 5, dans lequel la couche centrale (33) a une épaisseur comprise entre 400µm et 560µm.

7. Cantilever selon l'une des revendications 1 à 6, dans lequel chacune des deux couches (21,22,31,32) formées de fluorure de polyvinylidène a une épaisseur comprise entre 20µm et 50µm.

8. Cantilever selon l'une des revendications 1 à 7, dans lequel les deux couches (21, 22, 31, 32) formées de fluorure de polyvinylidène sont respectivement liées à la couche centrale (23, 33) par une résine époxy.

9. Cantilever selon l'une des revendications 1 à 8, dans lequel des électrodes (26a, 26b, 27a, 27b, 36a, 36b, 37a, 37b) sont formées sur et sous chacune des deux couches (21, 22, 31, 32) formées de fluorure de polyvinylidène.

10. Cantilever selon la revendication 9, dans lequel les électrodes (26a, 26b, 27a, 27b, 36a, 36b, 37a, 37b) sont formées d'aluminium, de nickel ou de cuivre.

11. Système de collecte d'énergie piézoélectrique, dans lequel le système (1) comprend un cantilever (2) selon l'une des revendications 1 à 10 et un dispositif (3) qui stocke ou utilise de l'énergie, et dans lequel une première extrémité (4) du cantilever (2) est connectée électriquement au dispositif (3) qui stocke ou utilise de l'énergie.

12. Système de collecte d'énergie piézoélectrique selon la revendication 11, dans lequel au moins une masse de pointe (8,10) est fixée à une deuxième extrémité (7) du cantilever (2), la deuxième extrémité (7) du cantilever (2) étant opposée à la première extrémité (4).

13. Système de récolte d'énergie piézoélectrique selon la revendication 12, dans lequel le poids d'au moins une masse de pointe (8,10) est configuré pour être personnalisé par la fréquence de résonance du système de récolte d'énergie piézoélectrique.

14. Système de collecte d'énergie piézoélectrique selon la revendication 12 ou 13, dans lequel une première masse de pointe (8) est fixée à un côté supérieur (9) de la deuxième extrémité (7) du cantilever (2), et dans lequel une deuxième masse de pointe (10) est fixée à un côté inférieur (11) de la deuxième extrémité (7) du cantilever (2).
